# EUROPEAN PATENT APPLICATION

(11) **EP 1 255 161 A1**
(43) Date of publication of application: **06.11.2002**
(21) Application number: 01974782.3
(22) Date of filing: 11.10.2001
(51) Int. Cl.: G03F 7/022, H01L 21/027

(54) **PHOTOSENSITIVE RESIN COMPOSITION**

(30) Priority: 31.10.2000 JP 2000331811
(71) Applicant: Clariant International Ltd., 4132 Muttenz 1 (CH)
(72) Inventor: TAKAHASHI, Shuichi, c/o Clariant(Japan)K.K., Ogasa-gun, Shizuoka 437-1496 (JP); IKEMOTO, Jun, c/o Clariant(Japan)K.K., Ogasa-gun, Shizuoka 437-1496 (JP); SHIODA, Hidekazu, c/o Clariant(Japan)K.K., Ogasa-gun, Shizuoka 437-1496 (JP); KAWATO, Shunji, c/o Clariant(Japan)K.K., Ogasa-gun, Shizuoka 437-1496 (JP)
(74) Representative: Hütter, Klaus, Dr.
(86) International application number: JP0108924
(87) International publication number: WO02037185

(57) **Abstract**

A radiation sensitive resin composition containing an alkali soluble resin and a quinonediazide group-containing photosensitizer, in which the photosensitizer comprises a mixture of two or more esters between tetrahydroxybenzophenone and 1,2-naphthoquinonediazidesulfonic acid having different esterification rates. As the photosensitizer, a mixture of photosensitizer A comprising an esterification product from tetrahydroxybenzophenone and 1,2-naphthoquinonediazide-5-sulfonic acid having an average esterification rate of X% (50 ≦ X ≦ 100) and photosensitizer B comprising an esterification product from tetrahydroxybenzophenone and 1,2-naphthoquinonediazide-5-sulfonic acid having an average esterification rate of Y% (25 ≦ Y ≦ (X-10)), with the mixing ratio A:B being 10 - 90 : 90 - 10, is preferred.

## Description

### Technical Field

This invention relates to a radiation sensitive resin composition and, more particularly, to a radiation sensitive resin composition adapted for producing semiconductor devices or flat panel displays (FPDs).

### Background Art

In the wide field including manufacture of semiconductor integrated circuits such as LSI, display panels of FPD, and circuit substrates for thermal heads etc., a photolithography technique has conventionally been employed for forming fine elements or conducting fine processing. In the photolithography technique, a positive-working or negative-working radiation sensitive resin composition is used for forming a resist pattern. Of these radiation sensitive resin compositions, a positive-working radiation sensitive resin composition that contains an alkali soluble resin and a photosensitizer of a quinonediazide compound has popularly been employed. As such composition, those with various compositions are described as, for example, "novolak resin/quinonediazide compound" in Japanese Examined Patent Publication No. S54-23570 (corresponding to US Patent No. 3,666,473), Japanese Examined Patent Publication No. S56-30850 (corresponding to US Patent No. 4,115.128), Japanese Unexamined Patent Publication No. S55-73045, Japanese Unexamined Patent Publication No. S61-205933, etc. Investigations on these compositions containing a novolak resin and a quinonediazide compound have been conducted with respect to the novolak resin and the photosensitizer. In respect of the novolak resins, radiation sensitive resin compositions with superior characteristics have been obtained by the improvement of physical properties and others of the resins hitherto known as well as the development of novel resins. For example, Japanese Unexamined Patent Publication Nos. S60-140235 and H1-105243 disclose a technique of providing a radiation sensitive resin composition having excellent properties by using a novolak resin with a particular molecular weight distribution, and Japanese Unexamined Patent Publication Nos. S60-97347 and S60-189739 and Japanese Patent Publication No. 2590342 disclose a technique of providing a radiation sensitive resin composition having excellent properties by using a novolak resin from which low-molecular portions of the resin has been removed.

However, integration degree of integrated circuits of semiconductor elements has increased year by year and, in the production of semiconductor elements or the like, processing of patterns with a line width of less than sub-micron order has become required. The above-described conventional techniques fail to fully meet the requirement. In addition, in the manufacture of display panel surfaces in liquid crystal displays (LCDs) and the like, it has been required, as mother glass plates become large-sized, to improve throughput (yield per unit time) in order to increase number of produced glass plates. In order to meet such requirement, it has been required to increase the sensitivity of a radiation sensitive resin composition and, in addition, it has also been required for the radiation sensitive resin composition to show high film-remaining properties and small process dependence in a baking or development process.

In order to enhance sensitivity of a radiation sensitive resin composition, it has generally been conducted to use a low-molecular weight resin or to reduce the amount of a photosensitizer. However, such techniques cause such problems as that heat resistance of the resist is decreased so much that etching resistance in the process of manufacturing semiconductor device is decreased, that developability is deteriorated, leaving scum (undeveloped portions), or that film-remaining rate is decreased. In order to solve such problems, there have so far been proposed a technique of using a resin of novolak resin mixture derived from a mixture of particular phenol compounds having a specific molecular weight range (Japanese Unexamined Patent Publication No. H7-271024), a technique of using a novolak resin derived from a particular phenol compound and having specific ranges of molecular weight, specific dispersion degree and specific dissolution rate in an alkali, and a polyhydroxy compound having phenolic hydroxyl groups (Japanese Unexamined Patent Publication No. H8-184963), a technique of using a radiation sensitive component containing an ester between trihydroxybenzophenone and naphthoquinonediazidesulfonic acid, and trihydroxybenzophenone in a specific ratio (Japanese Unexamined Patent Publication No. H8-82926), a technique of using, as a photosensitizer, a mixture of an ester between 2,3,4-trihydroxybenzophenone and 1,2-naphthoquinonediazide-5-sulfonic acid with a specific esterification rate and an ester between 2,3,4,4'-tetrahydroxybenzophenone and 1,2-naphthoquinonediazide-5-sulfonic acid with a specific esterification rate (Japanese Unexamined Patent Publication No. H2-109051), a technique of using, as a photosensitizer, an ester between a specific polyhydroxy compound and 1,2-naphthoquinonediazide-5-and/or -4-sulfonic acid, with the amount of tetraester component being specified (Japanese Unexamined Patent Publication No. H9-15853), and a technique of using, as a photosensitizer, a mixture of an ester between 2,3,4,4'-tetrahydroxybenzophenone and 1,2-naphthoquinonediazide-5-sulfonic acid and an ester between 2,3,4,4'-tetrahydroxybenzophenone and 1,2-naphthoquinonediazide-4-sulfonic acid at a specific mixing ratio (Japanese Unexamined Patent Publication No. H9-15853). However, none of these fully meets all of the aforesaid requirements. Thus, there have been desired a radiation sensitive resin composition that has a satisfactorily high sensitivity, satisfactorily high film-remaining properties, satisfactorily low process dependence and satisfactorily good pattern-forming properties.

With the above-described circumstances in mind, the present invention provides a radiation sensitive resin composition that can practically attain both high film-remaining properties and a high sensitivity and, in addition, has low process dependence and good pattern-forming properties.

### Disclosure of the Invention

As a result of intensive investigations, the inventors have found that the above-described object can be attained by using, as a photosensitizer component, a mixture of two or more photosensitizers having different average esterification rates in a radiation sensitive resin composition containing an alkali soluble resin and a quinonediazide group-containing photosensitizer, thus having achieved the present invention based on the finding.

That is, the present invention is a radiation sensitive resin composition containing an alkali soluble resin and a quinonediazide group-containing photosensitizer, in which the photosensitizer comprises a mixture of two or more esterification products from tetrahydroxybenzophenone and 1,2-naphthoquinonediazidesulfonic acid having different esterification rates.

The reason why the above-described object of the present invention is attained by using the radiation sensitive resin composition of the present invention may be considered as follows which, however, does not limit the present invention in any way.

That is, in the present invention wherein a mixture of a photosensitizer having a relatively higher esterification rate and a photosensitizer having a relatively lower esterification rate is used, it is considered that the photosensitizer having a relatively higher esterification rate exhibits the effect of improving the film-remaining rate and the photosensitizer having a relatively lower esterification rate exhibits the effect of forming a thick, slightly soluble surface layer. The photosensitizer having a relatively higher esterification rate has comparatively fewer free hydroxyl groups and, therefore, shows a relatively lower solubility in an alkali developer, thus showing a high film-remaining rate, but a slightly soluble layer to be formed on the surface of the radiation sensitive resin layer by the alkali developer upon development tends to become thin in thickness. On the other hand, the photosensitizer having a relatively lower esterification rate has a comparatively more free hydroxyl groups and, when used, it shows a decreased film-remaining rate but forms a thick slightly soluble surface layer. Hence, it is considered that, when a thick slightly soluble surface layer is formed by using the photosensitizer having a relatively lower esterification rate in combination, the thick slightly soluble layer functions as a dissolution-preventing layer upon development even in case where exposure and development of the radiation sensitive resin composition are conducted before a solvent is fully removed from the radiation sensitive resin, which serves to prevent the radiation sensitive resin composition from dissolving out from inside thereof and form a smooth surface layer. In case where a glass substrate is used as a substrate, temperature of the radiation sensitive resin composition on the glass substrate upon prebaking under the same conditions as with a silicone wafer is lower than that on the silicon wafer due to the lower thermal conductivity and higher thickness of the glass substrate than that of the silicon wafer, and hence the radiation sensitive composition on the glass plate tends to be exposed and developed in a state where the solvent is not fully removed yet. Thus, it seems that more preferred results are obtained by using the radiation sensitive resin composition of the present invention in manufacturing FPD or the like using a glass substrate as a substrate.

Further details of the present invention are described below.

The alkali soluble resin used in the radiation sensitive resin composition of the present invention may be any alkali soluble resin used in the conventional radiation sensitive composition known in the art which comprises an alkaline soluble resin and a photosensitizer containing quinonediazide group(s). Of the alkali soluble resins, a novolak resin is preferred. An alkali soluble novolak resin preferably used in the present invention is obtainable by a polycondensation between one kind of or a mixture of phenols and at least one kind of aldehydes such as formalin.

As the phenols to be used for preparing the novolak resin, there may be illustrated, for example, phenol, p-cresol, m-cresol, o-cresol, 2,3-dimethylphenol, 2,4-dimethylphenol, 2,5-dimethylphenol, 2,6-dimethylphenol, 3,4-dimethylphenol, 3,5-dimethylphenol, 2,3,4-trimethylphenol, 2,3,5-trimethylphenol, 3,4,5-trimethylphenol, 2,4,5-trimethylphenol, methylene-bisphenol, methylene-bis-p-cresol, resorcinol, catechol, 2-methylresorcinol, 4-methylresorcinol, o-chlorophenol, m-chlorophenol, p-chlorophenol, 2,3-dichlorophenol, m-methoxyphenol, p-methoxyphenol, p-butoxyphenol, o-ethylphenol, methylphenol, p-ethylphenol, 2,3-diethylphenol, 2,5-diethylphenol, p-isopropylphenol, α-naphthol, β-naphthol, and the like. These are used independently or as a mixture of two or more thereof.

As the aldehydes, there may be illustrated paraformaldehyde. acetaldehyde, benzaldehyde, hydroxybenzaldehyde, chloroacetaldehyde, etc. as well as formalin. These are used singly or as a mixture of two or more thereof.

The weight average molecular weight of the novolak resin used in the radiation sensitive resin composition of the present invention, as determined using polystyrene standards, is preferably 2,000 to 50,000, more preferably 3,000 to 40,000, and most preferably 4,000 to 30,000.

As the quinonediazide group-containing photosensitizers to be used in the radiation sensitive composition of the present invention, esterification products from tetrahydroxybenzophenone and 1,2-naphthoquinonediazidesulfonic acid are preferably used. The esterification products are preferably obtained by reacting a quinonediazidesulfonic acid halide such as naphthoquinonediazidesulfonic acid chloride with tetrahydroxybenzophenone. As the tetrahydroxybenzophenone, there are illustrated 2,3,4,4'-tetrahydroxybenzophenone, 2,2',4,4'-tetrahydroxybenzophenone, etc. As the quinonediazidesulfonic acid halide, there are illustrated 1,2-naphthoquinonediazide-4-, -5- or -6-sulfonic acid halide, with 1,2-naphthoquinonediazide-5-sulfonic acid halide being particularly preferred.

In the present invention, a mixture of two or more of esterification products from tetrahydroxybenzophenone and 1,2-naphthogulnonediazidesulfonic acid having different average esterification rates is used as the photosensitizer. As the mixture of two or more of the photosensitizers, a mixture of photosensitizer A comprising an esterification product from tetrahydroxybenzophenone and 1,2-naphthoquinonediazidesulfonic acid having an average esterification rate of X% (50≦X≦100) and photosensitizer B comprising an esterification product from tetrahydroxybenzophenone and 1,2-naphthoquinonediazidesulfonic acid having an average esterification rate of Y% (25≦Y≦(X-10)), with a mixing ratio A : B being 10 to 90 : 90 to 10, is preferred. A mixture with the mixing ratio of 30 to 70 : 70 to 30 is more preferred.

In the present invention, the term "average esterification rate" means an average value calculated from the constitution ratios of a mono-esterification product to a tetra-esterification product contained in the photosensitizer. Usually, in producing esterification products by reacting tetrahydroxybenzophenone with 1,2-naphthoquinonediazidesulfonic acid, there is obtained an esterification product as a mixture of two or more esters. In the present invention, the photosensitizer A or B may be the mixture of esterification products obtained by the synthetic reaction, may be a mixture of esterification products obtained by the synthetic reaction from which a part of the esters is removed, or may be a monoester, diester, triester or tetraester isolated from the mixture. In case where the photosensitizer comprises the isolated ester, the average esterification rate referred to in the present invention is 25% with a photosensitizer comprising the monoester, or 50%, 75% and 100% with photosensitizers comprising a diester, triester and tetraester, respectively.

In the present invention, a content of the photosensitizer comprising a mixture of two or more of esterification products from tetrahydroxybenzophenone and 1,2-naphthoquinonediazidesulfonic acid having different average esterification rates is preferably 10 to 30 parts by weight, more preferably 15 to 25 parts by weight, based on 100 parts by weight of the alkali soluble resin component in the radiation sensitive resin composition. If the content is less than 10 parts by weight, there tends to result in a decreased film-remaining rate whereas, if more than 30 parts by weight, there results in a too low sensitivity, thus such content being practically problematical.

In addition, in the radiation sensitive resin composition of the present invention may be used a low-molecular compound having phenolic hydroxyl group(s) as a dissolution-accelerating agent for adjusting dissolution rate of the radiation sensitive resin composition or for improving or adjusting sensitivity of the radiation sensitive resin composition.

As the low-molecular compound having phenolic hydroxyl group(s), there are illustrated, for example, o-cresol, m-cresol, p-cresol, 2,4-xylenol, 2,5-xylenol, 2,6-xylenol, bisphenol A, B, C, E, F, or G, 4,4',4"-methylidinetrisphenol, 2,6-bis[(2-hydroxy-5-methylphenyl)methyl]-4-methylphenol, 4,4'-[1-[4-[1-(4-hydroxyphenyl)-1-methylethyl]phenyl]ethylidene]bisphenol, 4,4',4"-ethylidinetrisphenol, 4-[bis(4-hydroxyphenyl)methyl]-2-ethoxyphenol, 4,4'-[(2-hydroxyphenyl)methylene)bis[2,3-dimethylphenol], 4,4'-[(3-hydroxyphenyl)methylene]bis[2,6-dimethylphenol], 4,4'-[(4-hydroxyphenyl)methylene]bis[2,6-dimethylphenol], 2,2'-[(2-hydroxyphenyl)methylene]bis[3,5-dimethylphenol], 2,2'-[(4-hydroxyphenyl)methylene]bis[3,5-dimethylphenol], 4,4'-[(3,4-dihydroxyphenyl)methylene]bis[2,3,6-trimethylphenol], 4-[bis(3-cyclohexyl-4-hydroxy-6-methylphenyl)methyl]-1,2-benzenediol, 4,6-bis[(3,5-dimethyl-4-hydroxyphenyl)methyl]-1,2,3-benzenetriol, 4,4'-[(2-hydroxyphenyl)methylene]bis[3-methyiphenol],4,4',4"-(3-methyl-1-propanyl-3-ylidine)trisphenol, 4,4',4",4'''-(1,4-phenylenedimethylidine)tetrakisphenol, 2,4,6-tris[(3,5-dimethyl-4-hydroxyphenyl)methyl]-1,3-benzenediol, 2,4,6-tris[(3,5-dimethyl-2-hydroxyphenyl)methyl]-1,3-benzenediol, 4,4'-[1-[4-[1-[4-hydroxy-3,5-bis[(hydroxy-3-methylphenyl]methyl]phenyl]-1-methylethyl]phenyl]ethylidene]bis[2,6-bis(hydroxy-3-methylphenyl)methyl]phenol, and the like. These low-molecular compounds having phenolic hydroxyl group(s) are used in an amount of usually 1 to 20 parts by weight, preferably 3 to 15 parts by weight relative to 100 parts by weight of the alkali soluble resin.

Further, in the radiation sensitive resin composition of the present invention may preferably be used a resin additive such as a polyacrylic acid ester, a polymethacrylic acid ester, a polystyrene derivative or a copolymer obtained from at least two monomers selected from among acrylic acid esters, methacrylic acid esters and styrene derivatives for adjusting dissolution rate of the radiation sensitive resin composition as a dissolution inhibitor or for improving or adjusting sensitivity of the radiation sensitive resin composition.

The examples of solvents for dissolving the alkali soluble resin, the photosensitizer, the low-molecular compound having phenolic hydroxyl group(s) and the resin additive of the present invention include ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactates such as methyl lactate and ethyl lactate; aromatic hydrocarbons such as toluene and xylene; ketones such as methyl ethyl ketone, 2-heptanone, and cyclohexanone; amides such as N,N-dimethylacetamide and N-methylpyrrolidone; lactones such as γ-butyrolactone; and so on. These solvents are used singly or as a mixture of two or more thereof.

Further, dyestuffs, adhesive aids, surfactants etc. may be incorporated as necessary into the radiation sensitive resin composition of the present invention. The dyestuffs include e.g. Methyl Violet, Crystal Violet, Malachite Green etc.; the adhesive aids include e.g. alkyl imidazoline, butyric acid, alkyl acid, polyhydroxystyrene, polyvinylmethyl ether, t-butyl novolak, epoxy silane, epoxy polymer, silane etc.; and the surfactants include e.g. nonionic surfactants such as polyglycols and derivatives thereof, that is, polypropylene glycol or polyoxyethylene lauryl ether, fluorine-containing surfactants such as Fluorad (trade name and manufactured by Sumitomo 3M Ltd.), Megafac (trade name and manufactured by Dainippon Ink & Chemicals, Inc.), Sulflon (trade name and manufactured by Asahi Glass Co., Ltd.) or organosiloxane surfactants such as KP341 (trade name and manufactured by Shin-Etsu Chemical Co., Ltd.).

### Example

The present invention will now be described more specifically by reference to Examples which, however, should not be construed to limit the present invention in any way.

### Example 1

100 parts by weight of novolak resin having a weight-average molecular weight of 8,000 as determined by polystyrene standards, 25 parts by weight of a mixture of an esterification product from 2,3,4,4'-tetrahydroxybenzophenone and 1,2-naphthoquinonediazide-5-sulfonyl chloride having an average esterification rate of 87.5% (Photosensitizer a) and an esterification product from 2,3,4,4'-tetrahydroxybenzophenone and 1,2-naphthoquinonediazide-5-sulfonyl chloride having an average esterification rate of 75.0% (Photosensitizer b) (mixing ratio a:b= 50:50), and 5 parts by weight of 4,4'-[1-[4-[1-(4-hydroxyphenyl)-1-methylethyl]phenyl]ethylidene]-bisphenol were dissolved in 390 parts by weight of propylene glycol monomethyl ether acetate and, further, a fluorine-containing surfactant, Megafac (made by Dainippon Ink & Chemicals, Inc.) was added thereto in an amount of 300 ppm based on the total solid components, followed by stirring and filtering through a 0.2-µm filter to prepare a radiation sensitive resin composition of the present invention. This composition was spin coated on a 4-inch silicon wafer and a 4-inch glass wafer, and baked on a hot plate at 100 °C for 90 seconds to obtain 1.5-µm thick resist films. Each of the resist films was exposed using a g+h line stepper: FX-604F made by Nikon Co., Ltd., followed by developing at 23°C for 60 seconds with a 2.38 wt % tetramethylammonium hydroxide aqueous solution. Film-remaining rate was calculated using values of the film thickness obtained by measuring the film thickness before and after the development. In addition, an exposure amount required for completely resolving an open frame was taken as sensitivity (Eₜₕ), and the state of a surface of a 5-µm pattern was observed. Thus, there were obtained results shown in Table 1.

### Examples 2 - 5 and Comparative Examples 1 and 2

The same procedures as in Example 1 were conducted except for changing the mixing ratio of Photosensitizers a and b as shown in Table 1 and properly changing the amount of the photosensitizer for the purpose of adjusting sensitivity to about the same degree as that of the radiation sensitive resin composition in Example 1. Thus, there were obtained results shown in Table 1.

### Comparative Examples 3 and 4

The same procedures as in Example 1 were conducted except for changing the mixing ratio of Photosensitizers a and b as shown in Table 1 (not changing the amount of the photosensitizer for adjusting sensitivity) to obtain the results shown in Table 1.

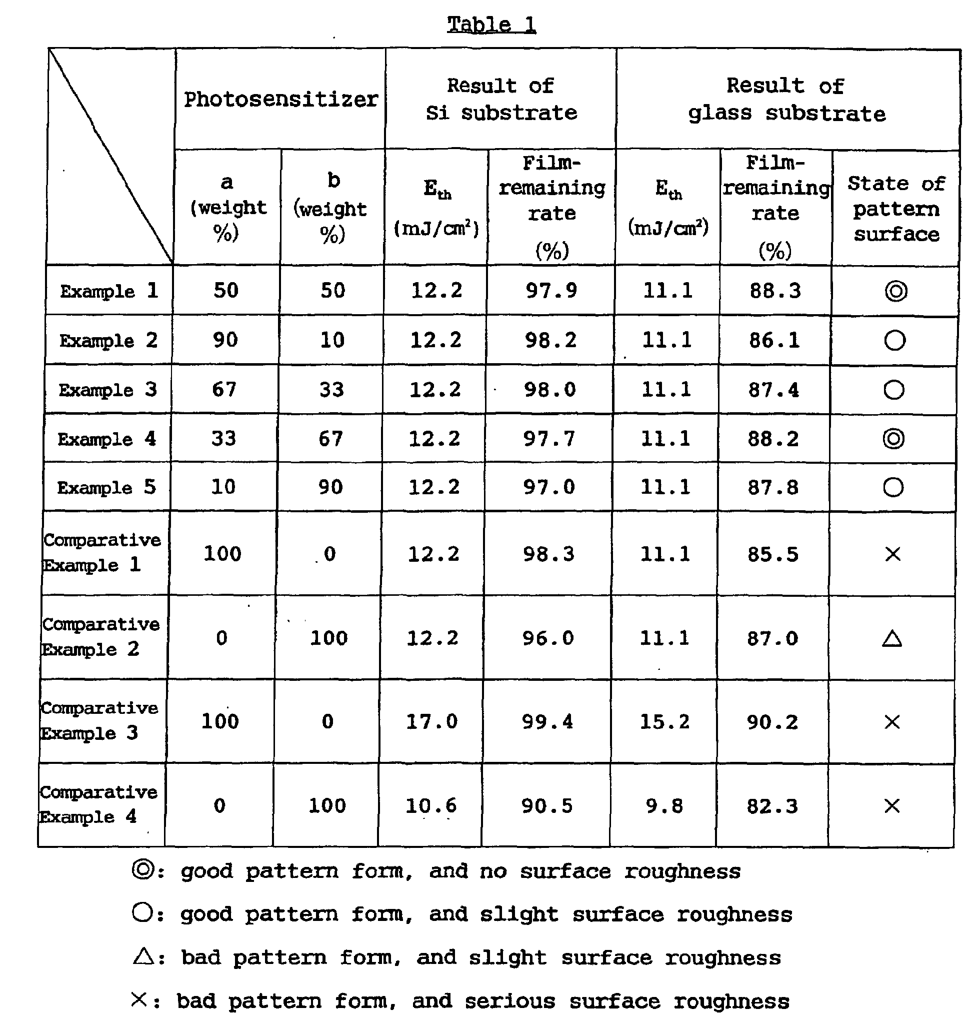

It is seen from Table 1 that results on sensitivity and film-remaining rate of the film on the silicon wafer were about the same in the Examples and Comparative Examples except for Comparative Examples 3 and 4, and no difference was observed with respect to results on the state of pattern surface. However, a great difference was observed between Examples and Comparative Examples as to the state of pattern surface of each film formed on a glass substrate which is used in practical production of FPD or the like. Even when processed under the same prebaking conditions, the radiation sensitive resin composition coated on the silicon wafer and that coated on the glass substrate showed significantly different temperature distributions from each other upon the prebaking due to difference in thickness between the silicon wafer and the glass substrate and in thermal conductivity between silicon and glass,. and the composition on the glass substrate is at a relatively lower temperature than the composition on the silicon wafer. The results shown in Table 1 reveals that, even when substantial temperature distribution in the radiation sensitive resin composition is different upon prebaking, the radiation sensitive resin composition of the present invention forms a pattern surface having no roughness which exerts detrimental influences on etching, shows a high film-remaining rate and can form a good pattern in comparison with the radiation sensitive composition shown in Comparative Examples and composed of a single photosensitizer, thus providing a composition having well balanced properties.

### Example 6

100 parts by weight of novolak resin having a weight-average molecular weight of 8,000 as determined by polystyrene standards, 25 parts by weight of a mixture of an esterification product from 2,3,4,4'-tetrahydroxybenzophenone and 1,2-naphthoquinonediazide-5-sulfonyl chloride having an average esterification rate of 87.5% (Photosensitizer a) and an esterification product from 2,3,4,4'-tetrahydroxybenzophenone and l,2-naphthoquinonediazide-5-sulfonyl chloride having an average esterification rate of 62.5% (Photosensitizer c)(mixing ratio: a:c = 50:50), and 5 parts by weight of 4,4'-[1-[4-[1-(4-hydroxyphenyl)-1-methylethyl]phenyl]-ethylidene]bisphenol were dissolved in 390 parts by weight of propylene glycol monomethyl ether acetate and, further, a fluorine-containing surfactant, Megafac (made by Dainippon Ink & Chemicals, Inc.) was added thereto in an amount of 300 ppm based on the total solid components, followed by stirring and filtering through a 0.2-µm filter to prepare a radiation sensitive resin composition of the present invention. This composition was spin coated on a 4-inch silicon wafer and a 4-inch glass wafer, and baked on a hot plate at 100 °C for 90 seconds to obtain 1.5-µm thick resist films. Each of the resist films was exposed using a g+h line stepper: FX-604F made by Nikon Co., Ltd., followed by developing at 23°C for 60 seconds with a 2.38 wt % tetramethylammonium hydroxide aqueous solution. Film-remaining rate was calculated using values of the film thickness obtained by measuring the film thickness before and after the development. In addition, an exposure amount required for completely resolving an open frame was taken as sensitivity (Eₜₕ), and the state of a 5-µm pattern surface was observed. Thus, there were obtained results shown in Table 2.

### Examples 7-10 and Comparative Example 5

The same procedures as in Example 6 were conducted except for changing the mixing ratio of Photosensitizer a and c as shown in Table 2 and properly changing the amount of the photosensitizer for the purpose of adjusting sensitivity to about the same degree as that of the radiation sensitive resin composition in Example 6. Thus, there were obtained results shown in Table 2.

### Comparative Example 6

The same procedures as in Example 6 were conducted except for changing the mixing ratio of Photosensitizer a and c as shown in Table 2 (not changing the amount of the photosensitizer for adjusting sensitivity) to obtain the results shown in Table 2.

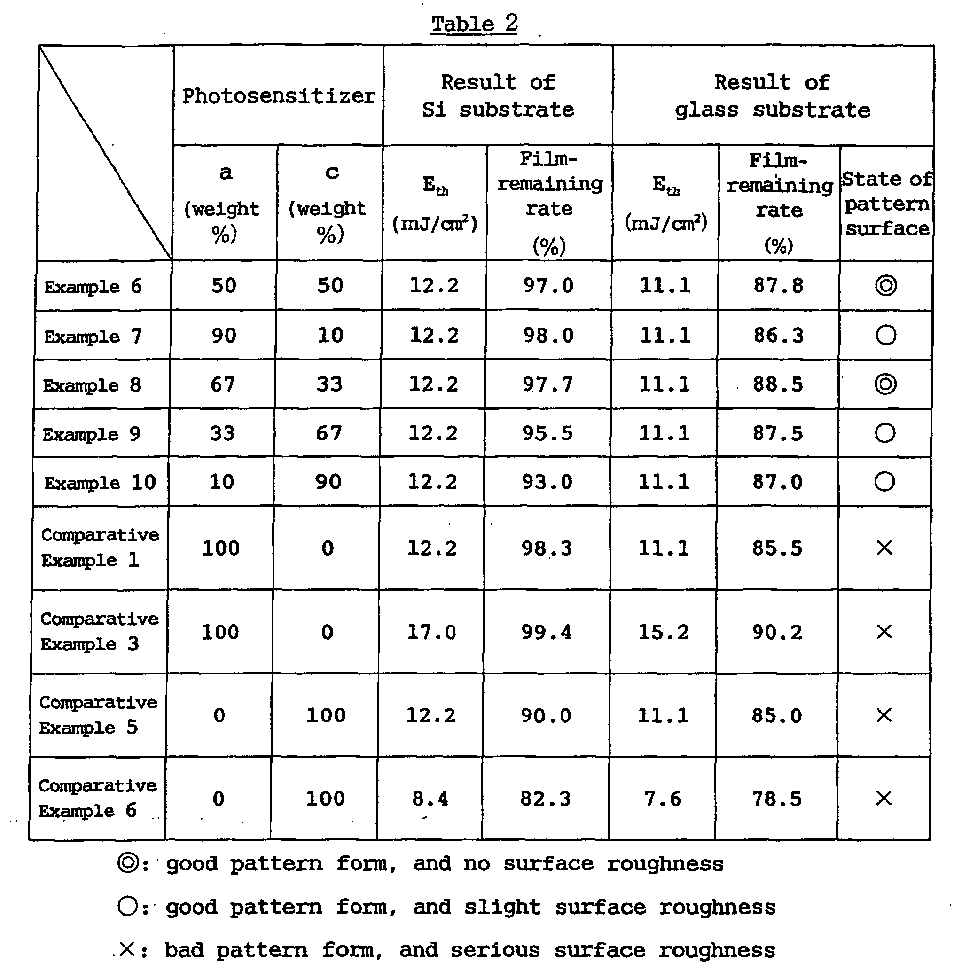

It is seen from Table 2 that, as long as a mixture of two or more photosensitizers having different average esterification rates is used, the same effects as shown in Table 1 can be obtained even when esterification rates of the two photosensitizers used are different from those in Examples 1 to 5. Comparison of the results of Example 6 in Table 2 with the results of Comparative Examples 2 and 4 in Table 1 reveals that, though the average esterification rates of the total photosensitizers of the radiation sensitive resin composition in these Examples and Comparative Example are the same 75%, use of a mixture of photosensitizers having a different average esterification rate (Example 6) provides a composition showing less rough pattern surface than in the case of using a single photosensitizer (Comparative Examples 2 and 4).

Additionally, all of the resist patterns obtained in Examples did not form scum, and showed a good shape. In addition, all radiation sensitive resin compositions of Examples showed low process dependence. From these results, it is seen that the radiation sensitive resin composition of the present invention provides a radiation sensitive resin composition showing well-balanced properties such as good sensitivity, good film-remaining rate and good pattern surface state by using a mixture of photosensitizers having different esterification rates.

### Advantage of the Invention

As has been described hereinbefore, the present invention provides a radiation sensitive resin composition that practically enables one to attain both a high film-remaining rate and a high sensitivity, which has low process dependence, and which can form a good pattern.

## Claims

1. A radiation sensitive resin composition comprising an alkali soluble resin and a photosensitizer having quinonediazide group, wherein the photosensitizer comprises a mixture of 2 or more esters different in the average esterification rate, which are esterification products from tetrahydroxybenzophenone and 1,2-naphthoquinonediazidesulfonic acid.

2. The radiation sensitive resin composition according to claim 1, wherein the photosensitizer is a mixture of photosensitizer A comprising an esterification product from tetrahydroxybenzophenone and 1,2-naphthoquinonediazidesulfonic acid having an average esterification rate of X% (50 ≦ X ≦ 100) and photosensitizer B comprising an esterification product form tetrahydroxybenzophenone and 1,2-naphthoquinonediazide-5-sulfonic acid having an average esterification rate of Y% (25 ≦ Y ≦ (X-10)), with a mixing ratio A : B is 10 to 90 : 90 to 10.
